(19) Europäisches Patentamt

European Patent Office

Office européen des brevets

(11) **EP 1 500 515 A2**

(12) **EUROPEAN PATENT APPLICATION**

(43) Date of publication:
26.01.2005 Bulletin 2005/04

(51) Int Cl.7: **B41J 2/465**, G06K 15/12

(21) Application number: 04017222.3

(22) Date of filing: 21.07.2004

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **22.07.2003 JP 2003277613**

(71) Applicant: **Fuji Photo Film Co., Ltd.**
**Minamiashigara-shi Kanagawa (JP)**

(72) Inventors:
• **Nakaya, Daisuke**
**Ashigarakami-gun Kanagawa-ken (JP)**

• **Fujii, Takeshi**
**Ashigarakami-gun Kanagawa-ken (JP)**
• **Shimoyama, Yuji**
**Ashigarakami-gun Kanagawa-ken (JP)**
• **Sumi, Katsuto c/o Fuji Photo Film Co., Ltd.**
**Kanagawa-ken (JP)**

(74) Representative: **Klunker . Schmitt-Nilson . Hirsch**
**Winzererstrasse 106**
**80797 München (DE)**

(54) **Addressing the imaging elements of a spatial light modulator in an image recording apparatus**

(57) In an image-recording apparatus: an image-recording head relatively moves with respect to an image-recording plane in a predetermined direction, and modulates incident light with a spatial light-modulation device containing a plurality of rows of image-recording elements, and each of the image-recording elements modulates the incident light according to one of control signals; and a control unit outputs ones of the control signals to each of a plurality of regions of the spatial light-modulation device each containing at least one of the plurality of rows of image-recording elements, on a region-by-region basis in succession, and controls image-recording elements in each of the plurality of regions on a region-by-region basis so that the image-recording elements in each of the plurality of regions start modulation of the incident light when an operation of inputting the ones of the control signals into the region is completed.

**FIG.9A**

**Description**

BACKGROUND OF THE INVENTION

Field of the Invention

The present invention relates to an image-recording apparatus in which an image-recording head having a spatial light-modulation device is relatively moved with respect to an image-recording plane in a predetermined direction along the image-recording plane, where a great number of rows of image-recording elements are arranged in the spatial light-modulation device, a great number of image-recording elements are arranged along a line in each row of image-recording elements, and each image-recording element modulates incident light according to an inputted control signal. The present invention also relates to an image-recording method using the above image-recording apparatus.

Description of the Related Art

The following documents (1) and (2) disclose information related to the present invention.

    (1) U.S Patent No. 6,201,521
    (2) U.S Patent Laid-Open No. 20020092993

Conventionally, various exposure systems in which images are exposed with light beams modulated according to image data by using a digital micromirror device (DMD) have been proposed. In each DMD, a plurality of micromirrors are two-dimensionally arranged in L rows X M columns above memory cells (SRAM cells) formed on a semiconductor substrate such as a silicon substrate. The tilt angle of the reflection surface of each micromirror is changed by controlling according to a control signal an electrostatic force caused by electric charges stored in a memory cell. Thus, actual exposure is realized by scanning an exposure plane with the DMD in a predetermined direction along the exposure plane.

In the DMD, when each micromirror is reset after image data (indicating "0" or "1") is written in an SRAM, the micromirror tilts at a predetermined angle (corresponding to the ON or OFF state) according to the image data so that the direction to which light is reflected can be changed.

Incidentally, in order to complete the resetting operations of all of the micromirrors, it is necessary to transfer data to SRAMs, and change the tilt angles of the micromirrors after the transfer. Therefore, sometimes it takes a long time until the resetting operations are completed.

In order to overcome the above problem, the aforementioned document (1) discloses an image display system in which a spatial light modulator (SLM) is divided into reset groups, and the respective groups are connected to different reset lines. In this image display system, image data are loaded and images are displayed in the following manner. That is, after one of the reset groups is loaded with image data, the reset group, which is already loaded with the image data, can start and perform an image display operation while loading another reset group with other image data.

However, the manner disclosed in document (1) is applied to an image display system, and an application to an image-recording apparatus using, for example, lithography is not intended in document (1).

In addition, for example, document (2) proposes an exposure method which realizes exposure with little jaggies by relatively moving a photosensitive material with respect to a DMD so that areas irradiated with light beams reflected by adjacent micromirrors partially overlap each other. However, since the times necessary to update micromirrors cause a bottleneck, it is difficult to increase the scanning speed. In addition, it is also difficult to increase the resolution in the scanning direction while maintaining the scanning speed.

SUMMARY OF THE INVENTION

The present invention has been developed in view of the above circumstances.

A first object of the present invention is to provide an image-recording method which can reduce the time necessary to update a spatial light-modulation device.

A second object of the present invention is to provide an image-recording apparatus which can reduce the time necessary to update a spatial light-modulation device.

A third object of the present invention is to provide an image-recording method which can increase the resolution in a scanning direction while maintaining a scanning speed.

A fourth object of the present invention is to provide an image-recording apparatus which can increase the resolution in a scanning direction while maintaining a scanning speed.

(I) In order to accomplish the above first object, the first aspect of the present invention is provided. According to the first aspect of the present invention, there is provided an image-recording method for recording an image by relatively moving an image-recording head with respect to an image-recording plane in a predetermined direction along the image-recording plane, and realizing image formation on the image-recording plane with incident light modulated by a spatial light-modulation device, where the spatial light-modulation device is included in the image-recording head, and contains a plurality of rows of image-recording elements, and each of the image-recording elements modulates the incident light according to one of a plurality of control signals which is inputted to the image-recording element. The image-recording method according to the first aspect of the present invention is characterized in comprising the steps of: (a) determining a plurality of regions each containing at least one of the plurality of rows of image-recording elements by dividing the plurality of rows of image-recording elements; (b) outputting ones of the plurality of control signals to each of the plurality of regions on a region-by-region basis in succession; and (c) controlling ones of the image-recording elements in each of the plurality of regions on a region-by-region basis so that the ones of the image-recording elements start modulation of the incident light when an operation of inputting ones of the plurality of control signals into the region is completed.

In the above description of the first aspect of the present invention, the term "row of image-recording elements" means a group of image-recording elements arranged along a line in one of two array directions in a two-dimensional arrangement of the image-recording elements, where the one of the two array directions forms a greater angle with the scanning direction than the other of the two array directions. In addition, the term "modulate" means to exert an effect on incident light by actuating an image-recording element.

The image-recording method according to the first aspect of the present invention may also have one or any possible combination of the following additional features (i) to (xiv).

(i) The plurality of control signals may be outputted to only a portion of the plurality of rows of image-recording elements, and the plurality of regions may be determined by dividing the portion of the plurality of rows of image-recording elements.

(ii) The number of the plurality of regions may satisfy a relationship, $d \geq t/(t-u)$, where d is the number of the plurality of regions, t is a time until operations of inputting the plurality of control signals into all of the plurality of regions are completed, and u is a time necessary for ones of the image-recording elements in each of the plurality of regions to modulate the incident light.

(iii) The number of at least one of the plurality of rows of image-recording elements constituting one of the plurality of regions may be different from the number of at least one of the plurality of rows of image-recording elements constituting another of the plurality of regions.

(iv) The image may be recorded in such a manner that image-recording points recorded by using the spatial light-modulation device are shifted in a scanning direction by an amount which is predetermined for each of the plurality of regions.

(v) Image-recording data corresponding to each of the image-recording points may be generated based on image data representing the image to be recorded on the image-recording plane, the amount predetermined for each of the plurality of regions, and a speed at which the image-recording head relatively moves with respect to the image-recording plane, and the plurality of control signals are generated based on the image-recording data.

(vi) The image may be recorded on the image-recording plane by performing multiple recording operations with a multiplicity of N, which is a natural number greater than one.

In the descriptions of the feature (vi), the term "multiple recording operations" means a process of recording an image by scanning an identical scanning line with a plurality of image-recording elements. When the number of the image-recording elements with which an identical scanning line is scanned is N, the term "multiple" means N-ple.

(vii) The number of the plurality of regions may be equal to the above natural number N.

(viii) When projected spots are produced on the image-recording plane by projection of the incident light modulated by at least a portion of the image-recording elements which is determined to be actually used for recording the image, the projected spots may be arranged along a direction which makes a predetermined angle with the scanning direction.

In the above description of the feature (viii), the direction along which the projected spots are arranged is one of two array directions in a two-dimensional arrangement of the image-recording elements, where the one of the two array directions forms a smaller angle with the scanning direction than the other of the two array directions.

(ix) The spatial light-modulation device may be arranged in such a manner that lines formed by ones of the image-recording elements form with the scanning direction a predetermined angle greater than zero.

(x) The image-recording elements may be arranged in the spatial light-modulation device in such a manner that lines formed by ones of the image-recording elements form with the scanning direction a predetermined angle greater than zero.

In the descriptions of the features (ix) and (x), the "lines formed by ones of the image-recording elements" are each a group of image-recording elements arranged along a line in one of two array directions in a two-dimensional arrangement of the image-recording elements, where the one of the two array directions forms a smaller angle with the scanning direction than the other of the two array directions.

(xi) The timings of output of the control signals to each of the plurality of regions may be adjusted according to a speed at which the image-recording head relatively moves with respect to the image-recording plane.

(xii) The timings of output of the control signals to each of the plurality of regions may be adjusted according to a desired arrangement of image-recording dots which are to be recorded on the image-recording plane.

(xiii) The control signals may be outputted to the plurality of regions in succession from the most downstream one of the plurality of regions in the scanning direction.

(xiv) The control signals to be outputted to each of the plurality of regions may be generated according to a speed at which the image-recording head relatively moves with respect to the image-recording plane.

(II) In order to accomplish the aforementioned second object, the second aspect of the present invention is provided. According to the second aspect of the present invention, there is provided an image-recording apparatus comprising an image-recording head which forms on a image-recording plane an image of incident light modulated by a spatial light-modulation device, and is relatively movable with respect to the image-recording plane in a predetermined direction along the image-recording plane, where the spatial light-modulation device is included in the image-recording head, and contains a plurality of rows of image-recording elements, and each of the image-recording elements modulates the incident light according to one of a plurality of control signals which is inputted to the image-recording element. The image-recording apparatus according to the second aspect of the present invention is characterized in further comprising a control unit which outputs ones of the plurality of control signals to each of a plurality of regions of the spatial light-modulation device each containing at least one of the plurality of rows of image-recording elements, on a region-by-region basis in succession, and controls ones of the image-recording elements in each of the plurality of regions on a region-by-region basis so that the ones of the image-recording elements start modulation of the incident light when an operation of inputting ones of the plurality of control signals into the region is completed.

The image-recording apparatus according to the second aspect of the present invention may also have one or any possible combination of the aforementioned additional features (ii), (iii), (vi), (viii), (ix), and (x) and the following additional features (xv) to (xxiv).

(xv) The plurality of regions may extend to only a portion of the plurality of rows of image-recording elements, and the control unit may output the plurality of control signals to only the portion of the plurality of regions.

(xvi) The control unit may output the control signals so that image-recording points recorded by using the spatial light-modulation device are shifted in a scanning direction by an amount which is predetermined for each of the plurality of regions.

(xvii) The control unit may generate image-recording data corresponding to each of the image-recording points based on image data representing the image to be recorded on the image-recording plane, the amount predetermined for each of the plurality of regions, and a speed at which the image-recording head relatively moves with respect to the image-recording plane, and the control unit also generates the plurality of control signals based on the image-recording data.

(xviii) In the control unit, the number of the plurality of regions may be set equal to the above natural number N.

(xix) The spatial light-modulation device may be a micromirror device in which a plurality of micromirrors are arranged as the image-recording elements, where each of the plurality of micromirrors has a reflection surface arranged at a tilt angle which is changeable according to one of the plurality of control signals.

(xx) The spatial light-modulation device may be a liquid-crystal shutter array in which a plurality of liquid-crystal cells are arranged as the image-recording elements, where each of the plurality of liquid-crystal cells can stop transmission of light according to one of the plurality of control signals.

(xxi) The control unit may adjust timings of output of the control signals to each of the plurality of regions according to a speed at which the image-recording head relatively moves with respect to the image-recording plane.

(xxii) The control unit may adjust timings of output of the control signals to each of the plurality of regions according to a desired arrangement of image-recording dots which are to be recorded on the image-recording plane.

(xxiii) The control unit may output the control signals to the plurality of regions in succession from the most downstream one of the plurality of regions in the scanning direction.

(xxiv) The control unit may generate the control signals to be outputted to each of the plurality of regions according to a speed at which the image-recording head relatively moves with respect to the image-recording plane.

(III) The present invention has the following advantages.

In the image-recording method according to the first aspects of the present invention and the image-recording apparatus according to the second aspects of the present invention, the plurality of rows of image-recording elements are divided into a plurality of regions, ones of the plurality of control signals are outputted to each of the plurality of regions on a region-by-region basis in succession, and ones of the image-recording elements in each of the plurality of regions are controlled on a region-by-region basis so that the ones of the image-recording elements start modulation of the incident light when an operation of inputting ones of the plurality of control signals into the region is completed. Therefore, it is possible to reset image-recording elements in one of the plurality of regions to which the transfer of control signals has already been completed, while transferring control signals to another of the plurality of regions. Thus, the time necessary to update the spatial light-modulation device can be reduced.

In addition, in the case where the control signals are outputted to only a portion of the image-recording elements in the above image-recording method and image-recording apparatus, the number of image-recording elements required to be controlled is reduced, and therefore the time necessary to update the spatial light-modulation device can be further reduced.

Further, the time necessary to update the spatial light-modulation device can be reduced more effectively when the number of the plurality of regions satisfies the relationship, $d \geq t/(t-u)$, where d is the number of the plurality of regions, t is a time until operations of inputting the plurality of control signals into all of the plurality of regions are completed, and u is a time necessary for ones of the image-recording elements in each of the plurality of regions to modulate the incident light.

Furthermore, when the number of at least one of the plurality of rows of image-recording elements constituting one of the plurality of regions is different from the number of at least one of the plurality of rows of image-recording elements constituting another of the plurality of regions, it is possible to reduce the number of the plurality of regions which are individually controlled, and therefore the control of the spatial light-modulation device can be simplified.

Moreover, when the spatial light-modulation device is arranged in the image-recording head in such a manner that the lines of image-recording elements in the spatial light-modulation device form with the scanning direction of the image-recording head a predetermined angle greater than zero, and the image is recorded with the image-recording head on the image-recording plane by performing multiple recording operations with a multiplicity of N (which is a natural number greater than one), and image-recording points recorded by using the spatial light-modulation device are shifted in the scanning direction by an amount which is predetermined for each of the plurality of regions, it is possible to increase the resolution in the scanning direction without decreasing the scanning speed, as explained later in detail.

DESCRIPTION OF THE DRAWINGS

FIG. 1 is a perspective view of an exposure system according to an embodiment of the present invention.
FIG. 2 is a schematic perspective view of a scanner in the exposure system according to the embodiment.
FIG. 3A is a plan view of a photosensitive material, and indicates exposed areas in the photosensitive material.
FIG. 3B is a diagram illustrating an arrangement of exposure areas produced by a plurality of exposure heads.
FIG. 4 is a schematic perspective view of one of the exposure heads in the exposure system according to the embodiment.
FIG. 5A is a cross-sectional view of the exposure head of FIG. 4, and illustrates a cross section cut in a subscanning direction so as to contain the optical axis of the exposure head.
FIG. 5B is a cross-sectional view of the exposure head of FIG. 4, and illustrates a cross section cut in a direction perpendicular to the subscanning direction.
FIG. 6 is a magnified perspective view of a portion of a digital micromirror device (DMD) used in the exposure head illustrated in FIG. 4.
FIGS. 7A and 7B are magnified perspective views of a portion, corresponding to a pixel, of the DMD used in the exposure head in the embodiment.
FIG. 8 is a schematic diagram illustrating divided regions of the DMD in one of the exposure heads in the embodiment.
FIG. 9A is a timing diagram indicating timings in the case where the divided reset actuation is performed, and the time necessary to update the micromirrors in each region is equal to the time necessary to transfer image data to the DMD.
FIG. 9B is a timing diagram indicating the time necessary to transfer image data to the DMD and the time necessary to update the micromirrors in each region in the case where the divided reset actuation is not performed.
FIG. 10A is a perspective view of a fiber-array light source.
FIG. 10B is a magnified view of a laser-emission portion of the fiber-array light source of FIG. 10A.
FIG. 10C is a magnified front view of a first example of the laser-emission portion of the fiber-array light source of FIG. 10A, and indicates a first example of arrangement of optical fibers in the laser-emission portion.

FIG. 10D is a magnified front view of a second example of the laser-emission portion of the fiber-array light source of FIG. 10A, and indicates a second example of arrangement of optical fibers in the laser-emission portion.

FIG. 11 is a plan view of a combined-laser-light source used in the embodiment.

FIG. 12 is a plan view of a laser module containing the combined-laser-light source illustrated in FIG. 11.

FIG. 13 is a side view of the laser module of FIG. 12.

FIG. 14 is a front view of a portion of the laser module of FIG. 12.

FIG. 15 is a timing diagram indicating timings in the case where the divided reset actuation is performed, and the time necessary to update the micromirrors in each region is smaller than the time necessary to transfer image data to the DMD.

FIG. 16 is a timing diagram indicating timings in the case where the divided reset actuation is performed, and the time necessary to transfer image data to the DMD is smaller than the time necessary to update the micromirrors in each region.

FIG. 17 is a timing diagram indicating timings in the case where the numbers of micromirror arrays in the regions 1 through 3 are 96, 96, and 48, respectively.

FIG. 18A is a diagram illustrating exposed areas produced with the exposure heads 166, which are arranged so that DMDs are rotated from the scanning direction as illustrated in FIG. 18B.

FIG. 18B is a diagram illustrating an arrangement of exposure areas of the exposure heads 166.

FIG. 19 is a diagram illustrating another arrangement of micromirrors in a DMD.

FIGS. 20A, 20B, and 20C are diagrams illustrating exposed areas produced by multiple exposure, in which each scanning line is scanned with three different micromirrors.

FIGS. 21A, 21B, and 21C are diagrams illustrating exposed areas produced by multiple exposure while performing the divided reset actuation.

FIGS. 22A and 22B are diagrams provided for explaining the relationships between images exposed on the photosensitive sheet 150 and control signals inputted into a DMD 50 in the case where the divided reset actuation is performed.

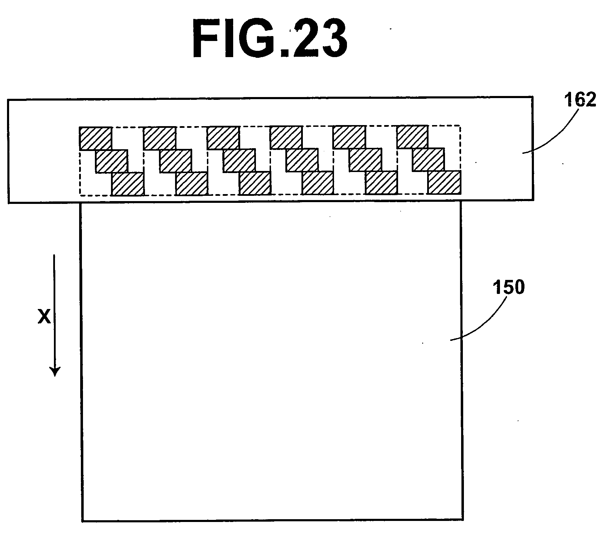

FIG. 23 is a plan view of a photosensitive material, which is provided for explaining a method for exposing the photosensitive material with a scanner in a single scanning cycle.

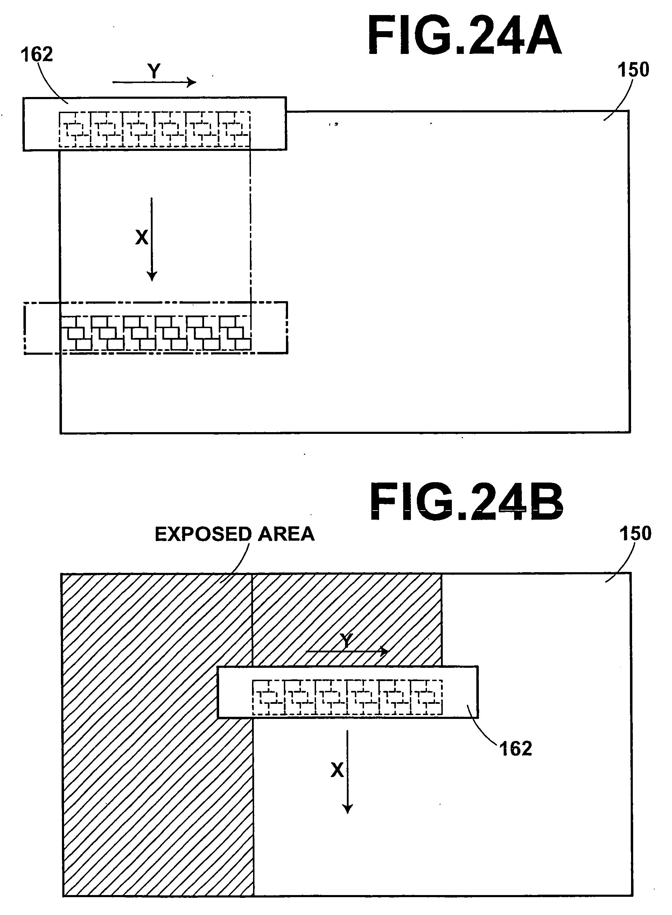

FIGS. 24A and 24B are plan views of a photosensitive material, which are provided for explaining a method for exposing the photosensitive material with a scanner in a plurality of scanning cycles.

## DESCRIPTION OF PREFERRED EMBODIMENTS

An embodiment of the present invention will be described in detail below with reference to the attached drawings. Although numerical values are indicated in the following descriptions, the present invention is not limited to such numerical values.

### Construction of Exposure System

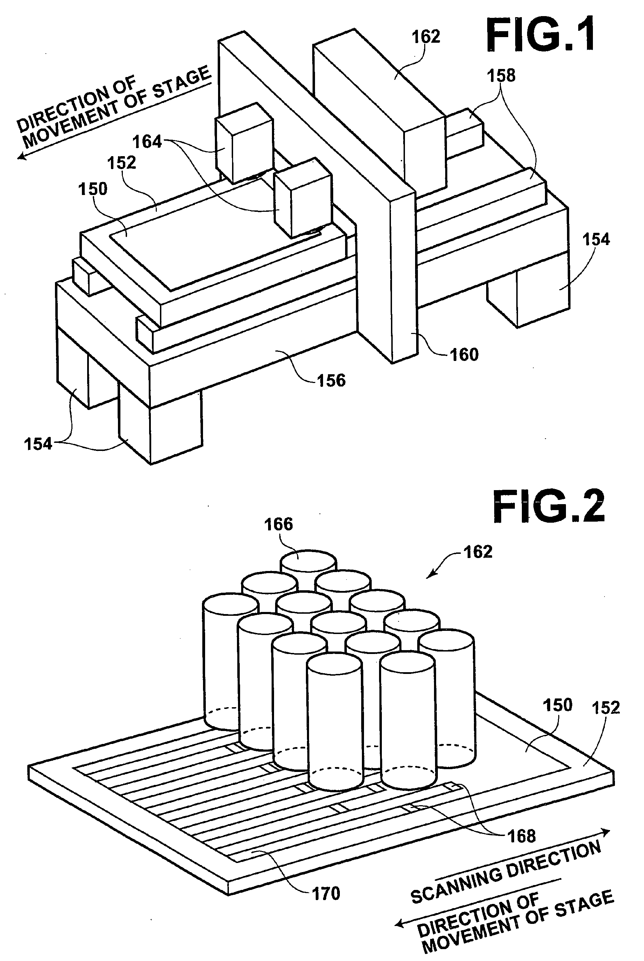

The image-recording apparatus according to an embodiment of the present invention is an exposure system of a so-called flat-head type. As illustrated in FIG. 1, the image-recording apparatus comprises a stage 152, which holds a photosensitive sheet 150 on its surface by suction. Two guides 158 extending in a direction along which the stage moves are arranged on an upper surface of a mount table 156, which is formed of a thick plate supported by four legs 154. The stage 152 is placed on and supported by the guides 158 so that the length direction of the stage 152 corresponds to the direction along which the stage 152 moves, and the stage 152 can move in either direction. In addition, the exposure system of FIG. 1 is provided with a driving device (not shown) for moving the stage 152 along the guides 158. The driving device is controlled by a controller (not shown) so that the stage 152 is moved at a moving speed (scanning speed) corresponding to a desired magnification ratio in the scanning direction.

A U-shaped gate 160 is arranged at the center of the mount table 156 so as to straddle the movement path of the stage 152. Two ends of the U-shaped gate 160 are respectively fixed to side surfaces of the mount table 156. A scanner 162 is fixed to one side of the U-shaped gate 160, and a plurality of sensors 164 (e.g., two sensors) are fixed to the other side of the U-shaped gate 160, in such a manner that the scanner 162 and the sensors 164 are fixedly located above the path of the stage 152. The plurality of sensors 164 are provided for detecting front and rear edges of the photosensitive sheet 150. The scanner 162 and the sensors 164 are connected to a controller (not shown) which controls the scanner 162 and the sensors 164. As will be described later, the scanner 162 and the sensors 164 are controlled so that the exposure heads 166 perform exposure at predetermined timings.

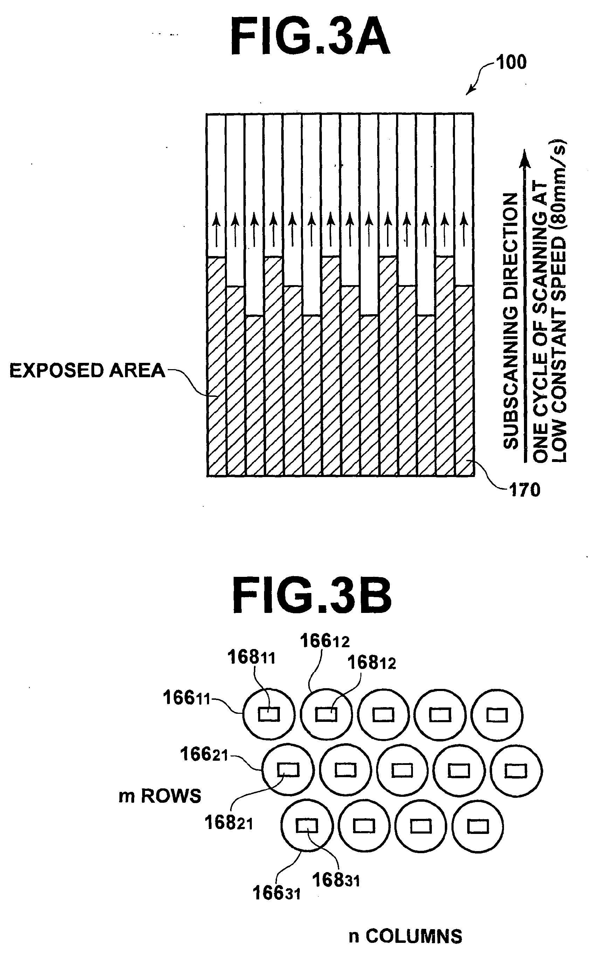

As illustrated in FIGS. 2 and 3B, the scanner 162 comprises a plurality of exposure heads 166 (e.g., fourteen exposure heads) which are arranged nearly in a matrix with m rows and n columns (e.g., a matrix with three rows and five columns). The plurality of exposure heads 166 constitute an exposure head unit 165. In particular, according to the present embodiment, more than one exposure head is arranged in a direction perpendicular to the scanning direction. Hereinafter, the direction perpendicular to the scanning direction is referred to as the head-array direction. In this example, five exposure heads are arranged in each of the first and second rows, and four exposure heads are arranged in the third row, based on consideration of the width of the photosensitive sheet 150. Hereinafter, for example, the exposure head located in the mth row and the nth column is indicated by the reference numeral $166_{mn}$.

As illustrated in FIG. 2, the exposure area $168_{mn}$ exposed with each exposure head $166_{mn}$ has a rectangular shape, and the shorter side of each exposure area is oriented in the scanning direction. Therefore, when the stage 152 moves, bandlike exposed areas 170 are formed on the photosensitive sheet 150 in correspondence with the exposure heads 166, respectively. Hereinafter, for example, the exposure area exposed by the exposure head $166_{mn}$ in the mth row and the nth column is indicated by the reference numeral $168_{mn}$.

In addition, as illustrated in FIGS. 3A and 3B, in order that the bandlike exposed areas 170 are closely arranged in the head-array direction, exposure heads linearly arranged in each row are shifted by a predetermined amount in the head-array direction from exposure heads linearly arranged in an adjacent row. Therefore, for example, areas which are located between the exposure areas $168_{11}$ and $168_{12}$ and are not exposed with the exposure heads $166_{11}$ and $166_{12}$ in the first row can be covered by the exposure areas $168_{21}$ and $168_{31}$ of the exposure heads $166_{21}$ and $166_{31}$ in the second and third rows.

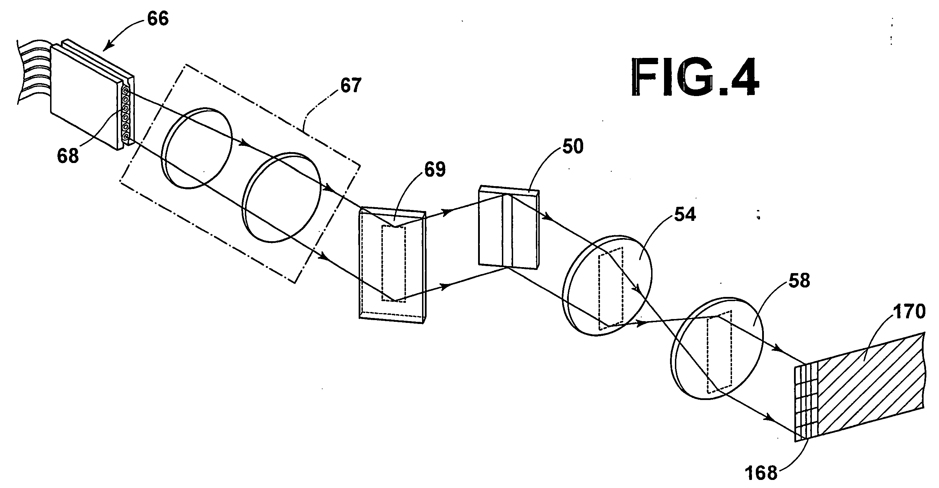

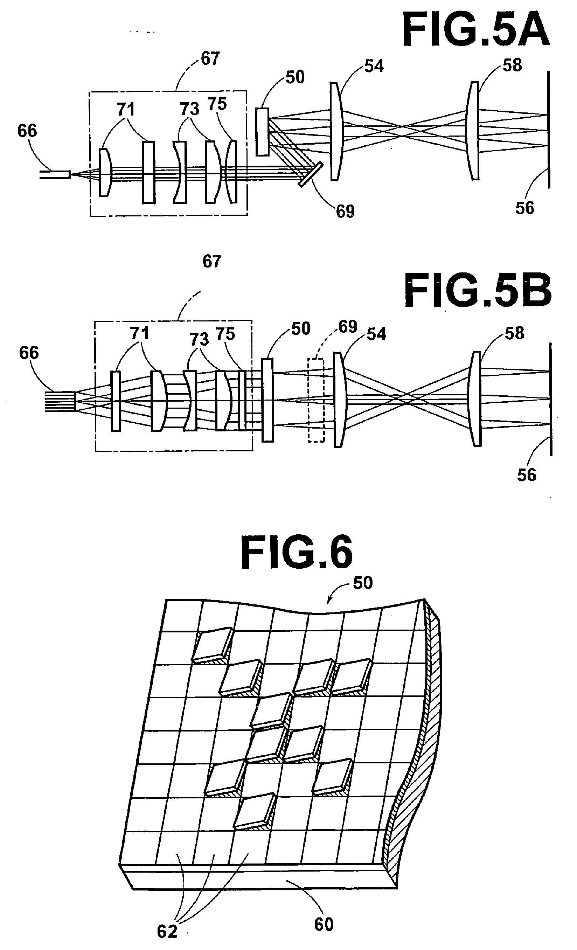

As illustrated in FIGS. 4, 5A, and 5B, each of the exposure heads $166_{11}$ to $166_{mn}$ comprises a digital micromirror device (DMD) 50 as a spatial light-modulation device, which spatially modulates a light beam incident on the DMD 50, according to image data on a pixel-by-pixel basis. The DMD 50 is connected to a controller (not shown) which comprises a data processing unit and a mirror actuation unit. The data processing unit in the controller generates control signals for each exposure head $166_{mn}$ control signals for controlling actuation of respective micromirrors in a specific area of the DMD 50 to be controlled, according to the image data, which are inputted to the controller. The controller has a function of transforming the image data so as to increase the resolution in the column direction above the resolution of the original image. When the resolution is increased as above, it is possible to perform various types of processing and corrections of the image data with higher accuracy.

In addition, the mirror-actuation control unit controls the tilt angles of reflection surfaces of the respective micromirrors in the DMD 50 constituting each exposure head $166_{mn}$ based on the control signals generated by the data processing unit.

On the light-entrance side of the DMD 50, a fiber-array light source 66, a lens system 67, and a mirror 69 are arranged in this order. The fiber-array light source 66 comprises a laser emission unit in which emission-end portions (light-emission points) of optical fibers are arranged to form a row along a direction corresponding to the longer sides of the exposure areas 168. The lens system 67 corrects laser light outputted from the fiber-array light source 66 so that the corrected laser light condenses on the DMD. The mirror 69 reflects the laser light which has passed through the lens system 67, toward the DMD 50.

The lens system 67 comprises a first pair of combined lenses 71, a second pair of combined lenses 73, and a condensing lens 75. The first pair of combined lenses 71 collimates the laser light outputted from the fiber-array light source 66, and the second pair of combined lenses 73 corrects the distribution of the intensity of the collimated laser light so as to make the distribution uniform. The condensing lens 75 condenses the laser light corrected by the second pair of combined lenses 73 onto the DMD. In the correction of the distribution of the intensity of the collimated laser light, each light beam is widened when the light beam passes through a portion of the second pair of combined lenses 73 near to the optical axis of the second pair of combined lenses 73 in the direction along which the light-emission points are arranged, or narrowed when the light beam passes through a portion of the second pair of combined lenses 73 far from the optical axis of the second pair of combined lenses 73, and the widths of the light beams in the direction perpendicular to the direction along which the light-emission points are not changed, so that the distribution of the intensity of the laser light becomes uniform.

Further, lens systems 54 and 58 are arranged on the light-output side of the DMD 50 so that an image of the laser light reflected by the DMD 50 is formed on a scanning plane (exposure plane) 56, and the DMD 50 and the exposure plane 56 are optically conjugate to each other.

As illustrated in FIG. 6, the DMD 50 is a mirror device constituted by a great number of micromirrors 62 (e. g., 1024 X 756 micromirrors) being arranged in a matrix (e.g., with a pitch of 13.68 micrometers) and each realizing a pixel. Each micromirror 62 is supported by a post arranged on an SRAM cell (memory cell) 60. That is, a micromirror 62, which is supported by a post, is arranged at the top in each pixel, and a surface of the micromirror 62 is coated by evaporation with a highly reflective material such as aluminum. The reflectance of each micromirror 62 is 90% or greater. A silicon-gate CMOS SRAM cell 60 is arranged under each micromirror 62 through a post having a hinge and a yoke, where the silicon-gate CMOS SRAM cell 60 is produced through a conventional manufacturing process of semiconductor memories, and the entire structure is monolithically (integrally) formed.

When a digital signal is written in an SRAM cell 60 in the DMD 50, a micromirror supported by a post tilts around a diagonal of the micromirror $\pm \alpha$ degrees (e.g., 10 degrees) with respect to a substrate on which the DMD 50

EP 1 500 515 A2

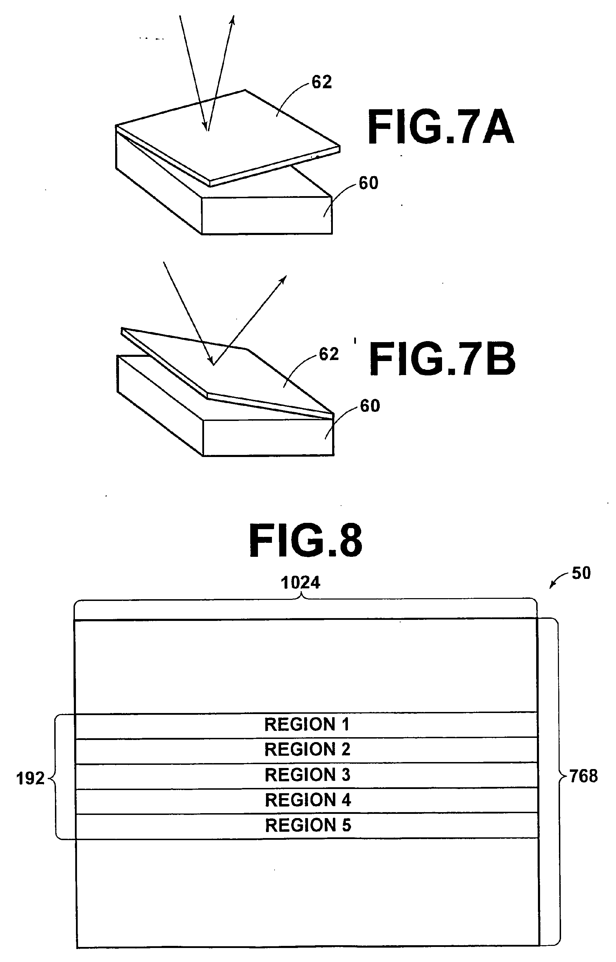

is formed. FIG. 7A shows the ON state in which the micromirror tilts +α degrees, and FIG. 7B shows the OFF state in which the micromirror tilts - α degrees. Therefore, when the inclinations of the micromirrors 62 in the respective pixels of the DMD 50 are controlled according to an image signal, for example, as illustrated in FIG. 6, a plurality of portions of light incident on the DMD 50 are reflected to the directions corresponding to the inclinations of the respective micromirrors 62.

FIG. 6 is a magnified perspective view of a portion of the DMD, which is in a state in which the inclinations of the respective micromirrors 62 are controlled to be +α or - α degrees. The on-off control of the micromirrors 62 is performed by the controller (not shown) which is connected to the DMD 50. In addition, a light absorber (not shown) is placed in the direction to which one or more portions of the incident light are reflected by one or more portions of the micromirrors which are in the OFF state.

Actuation of DMD

In the present embodiment, the controller controls the actuation of the DMD so as to use only a portion of the micromirrors 62, e.g., only 192 rows located in a central area of the micromirrors 62 having 768 rows arranged in the scanning direction, as illustrated in FIG. 8. Hereinafter, the actuation of the DMD 50 performed in such a manner that only a portion of the pixels (micromirrors 62) is used, will be referred to as partial actuation.

Since, generally, the data processing speed of the DMD 50 is limited, the time necessary to update pixels in each row is determined according to the number of used pixels. In order to update the micromirrors, both of the time for transferring digital signals to the SRAM cells and writing the digital signals in the SRAM cells and the time for resetting the respective micromirrors are necessary. Therefore, if all of the micromirrors 62 are used, the time for transferring the digital signals to all of the SRAM cells 60 is necessary. On the other hand, according to the present embodiment, the DMD 50 is partially actuated, i.e., only a portion of the micromirror rows is used. Therefore, the time necessary to transfer digital signals to the SRAM cells is reduced in correspondence with the reduction in the number of the used micromirrors.

Preferably, the number of the used micromirror rows is not less than 10 and not greater than 240. In this embodiment, it is assumed that the size of a micromirror corresponding to each pixel is 15 X 15 micrometers. Therefore, the preferable size of the used area of the DMD 50 corresponding to the above preferable range of the number of the used micromirror rows is from 12 mm X 150 micrometers to 12 mm X 3.6 mm.

When the number of the used micromirror rows corresponds to the above preferable size, the lens system 67 can almost completely collimate the laser light emitted from the fiber-array light source 66 so that the collimated laser light enters the DMD 50 as indicated in FIGS. 5A and 5B. It is preferable that the area of the DMD 50 to which the collimated laser light is applied coincides with the used area of the DMD 50. When the area of the DMD 50 to which the collimated laser light is applied is greater than the used area of the DMD 50, the utilization efficiency of the laser light decreases.

In order to partially actuate the DMD 50, the used area of the DMD 50 may be micromirror rows located in either a central or near-edge area in the scanning direction. In addition, the used area of the DMD 50 may be changed as circumstances demand. For example, when a defect occurs in a portion of the micromirrors 62, one or more micromirror rows which contain no defective micromirror may be used instead of the portion having the defect. Further, an effect equivalent to that of the above partial actuation can be achieved by using a DMD which is produced so as to contain only micromirror rows corresponding to the aforementioned preferable size.

Furthermore, according to the present embodiment, as illustrated in FIG. 8, the 1,024 X 192 micromirrors (i. e., 1,024 X 192 pixels of the SRAM cells 60) used in the partial actuation are divided into five regions 1 to 5 extending in the direction perpendicular to the scanning direction, where each of the regions 1 through 3 contains 38 micromirror arrays, and each of the regions 4 and 5 contains 39 micromirror arrays. The digital signals are transferred to the regions 1 to 5 of the SRAM cells 60 region by region in order of the arrangement of the regions 1 to 5, and the operation of resetting the micromirrors in each region is started when the transfer of the digital signals to the region is completed. Hereinafter, the division of the pixels (micromirrors) of the DMD 50 and the transfer of image data and the resetting of the micromirrors on a region-by-region basis will be referred to as divided reset actuation. When the divided reset actuation is performed, it is possible to concurrently perform the operation of transferring digital signals to the SRAM cells 60 and the operation of resetting the micromirrors, and substantially hide the time necessary to reset the micromirrors behind the time necessary to transfer the digital signals. Therefore, the time necessary to update the pixels of the DMD 50 can be reduced.

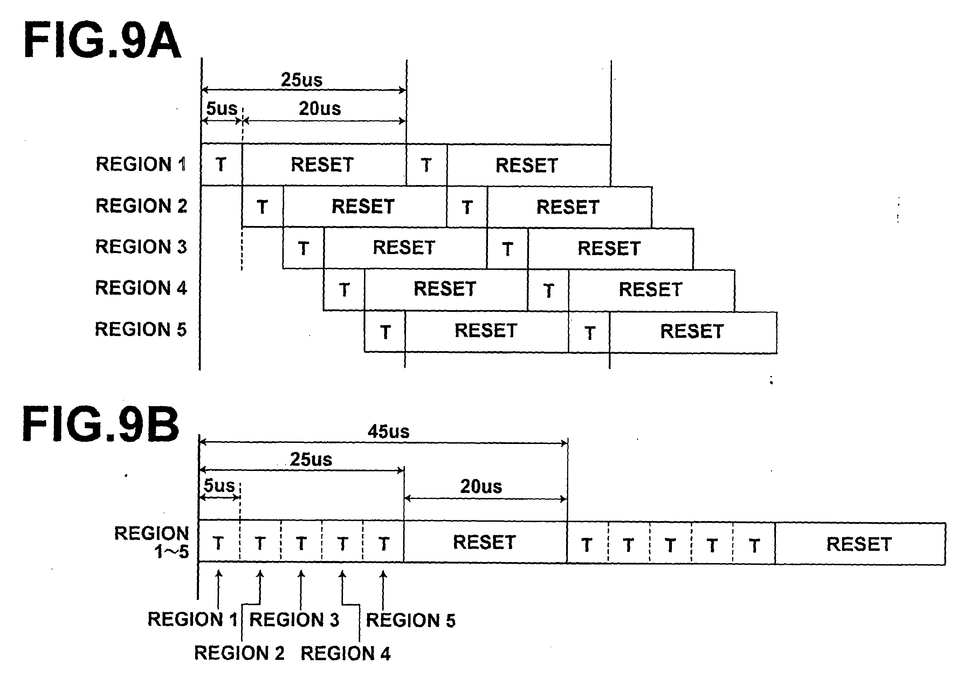

FIG. 9A shows timings in the case where the divided reset actuation is performed on the above regions 1 to 5 according to the present embodiment. In addition, for comparison, FIG. 9B shows timings in the case where the divided reset actuation is not performed.

In the operations of FIG. 9B, it takes 5 microseconds to transfer the digital signals to each of the regions 1 to 5. In addition, it takes 20 microseconds to reset the micromirrors in the regions 1 to 5 regardless of whether or not the micromirrors are divided into the regions. That is, in the case where the divided reset actuation is not performed, it takes 25 microseconds (5 X 5 microseconds) to transfer the digital signals to the regions 1 to 5, and thereafter the micromirrors are reset. Therefore, it takes 45 microseconds in all to update the pixels. This value is indicated in Table 1, which is referred to later.

On the other hand, in the case where the divided reset actuation is performed according to the present embodiment, as indicated in FIG. 9A, first, digital signals are transferred to the region 1 of the SRAM cells 60. Immediately after completion of the above transfer to the region 1, the operation of resetting the micromirrors in the region 1 is performed while transferring digital signals to the region 2 of the SRAM cells 60. Although the time (5 microseconds) to transfer digital signals to each region is shorter than the time (25 microseconds) to reset the micromirrors in the region, the operations of transferring digital signals to the regions 2, 3, 4, and 5 are performed one after another. The times for performing the operations of transferring digital signals to the regions 2, 3, 4, and 5 overlap with the times for resetting the micromirrors. Therefore, the time necessary to update the pixels of the DMD 50 can be reduced.

As described above, according to the present embodiment, both of the partial actuation and the divided reset actuation are performed. Therefore, compared with the case where only one of these method is performed, the time necessary to update the pixels of the DMD 50 is remarkably reduced. Table 1 shows examples of the times necessary to update the pixels of the DMD 50 in the four cases which are determined based on whether or not the partial actuation is performed and whether or not the divided reset actuation is performed. In Table 1, the ratio of the time necessary to update the pixels in each case to the time necessary to update the pixels in the case where neither of the partial actuation and the divided reset actuation is performed is indicated in parentheses.

As indicated in Table 1, the time necessary to update the pixels can be reduced to about 83% when only the divided reset actuation is performed, and to about 38% when only the partial actuation is performed. On the other hand, according to the present embodiment, the time necessary to update the pixels can be reduced to about 20% due to a synergistic effect of the partial actuation and the divided reset actuation.

Table 1

| Partial Actuation \ Divided Reset Actuation | No | Yes |
|---|---|---|
| No | 120μs (100%) | 100μs (83%) |
| Yes | 45μs (38%) | 25μs (20%) |

Although, in the example illustrated in FIG. 9A, the time necessary for completing the operations for updating of the pixels of the region 1 (i.e., the operation of transferring digital signals to the region 1 of the SRAM cells 60 and the operation of resetting the micromirrors in the region 1) is equal to the time necessary for completing transfer of the digital signals to all of the regions 1 to 5, it is unnecessary that these times are equal.

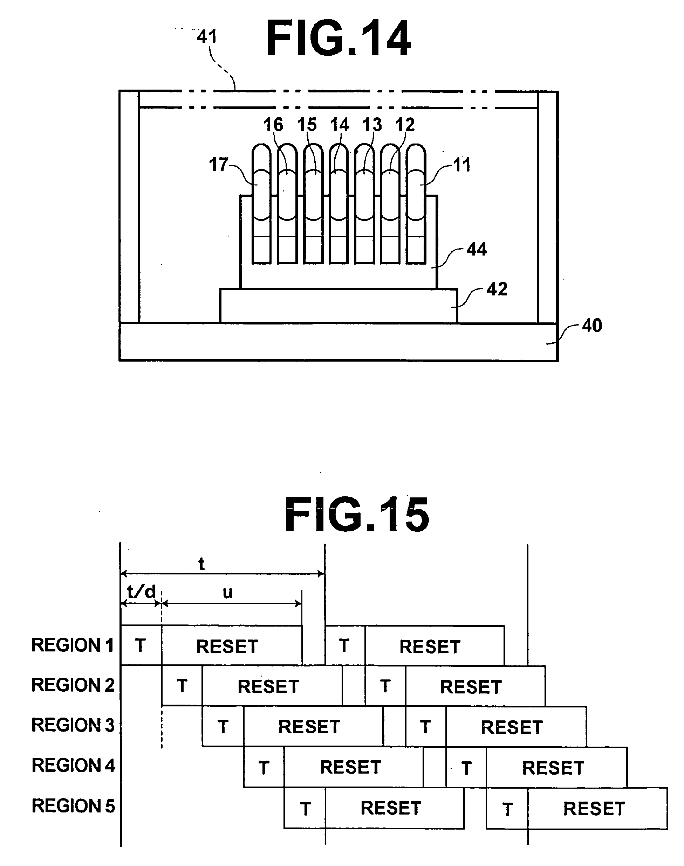

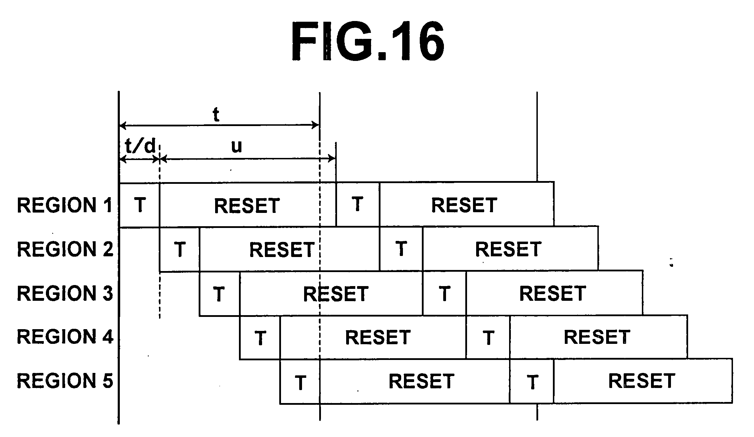

Generally, when the time necessary to transfer the digital signals to all of the regions 1 to 5 is indicated by t, and the time necessary to reset the micromirrors in each of the regions 1 to 5 is indicated by u, and the number of the regions 1 to 5 is indicated by d, the time necessary for completing updating of the pixels of all of the regions 1 to 5 (i. e., the modulation time) is equal to a greater one of t and t/d+u. For example, in the example illustrated in FIG. 15, the time t necessary to transfer the digital signals to all of the regions 1 to 5 is greater than the time t/d+u for completing updating of the pixels of a specific one of the regions 1 to 5. On the other hand, in the example illustrated in FIG. 16, the time t/d+u for completing updating of the pixels of a specific one of the regions 1 to 5 is greater than the time t necessary to transfer the digital signals to all of the regions 1 to 5. As mentioned above, in the example illustrated in FIG. 9A, the time t and the time t/d+u are equal.

However, in the example illustrated in FIG. 16, for example, at the time of completion of transfer of digital signals to all of the regions 1 to 5 of the SRAM cells 60, the operation of resetting the micromirrors in the region 1 is not completed, and therefore it is impossible to write in the next digital signals in the region 1 of the SRAM cells 60.

This problem can be solved by increasing the number d of division so as to satisfy the relationship,

$$d \geq t/(t-u),$$

where t>u. For example, since, in the example of FIG. 9A, t=25 microseconds and u=20 microseconds, $d \geq 25/(25-20)$ =5. Therefore, in this case, when the number d of division is five or greater, the time necessary to reset the micromirrors of each of the regions 1 to 5 is completely hidden behind the time necessary to transfer digital signals to all of the regions 1 to 5 of the SRAM cells 60. Thus, it is possible to save time and reduce the time necessary to update the pixels of the DMD 50.

Incidentally, it is preferable that the time t1 to transfer a digital signal to the SRAM cells 60 is shorter than the modulation time t2 (the time t2 to update one pixel (one micromirror)), i.e., $t1 \leq t2$. When the scanning speed of the exposure heads 166 is indicated by v, and the distance (exposure pitch) in the scanning direction by which the photosensitive sheet 150 moves until a pixel is updated is indicated by r, the modulation time t2 of a pixel is r/v. In addition, when m rows out of M rows arranged in the scanning direction are used, and the transfer time necessary to transfer digital signals to all of the M rows is indicated by T, the time t1 necessary to transfer digital signals to the used rows of the SRAM cells 60 is T X (m/M). Therefore, it is preferable that T X $(m/M) \leq r/v$, i.e., $m \leq Mr/vT$. For example, when M=768, and v=80 mm/sec, and r=2 micrometers, and T=100 microseconds, Mr/vT=192. In the above examples, the number m of the used rows is determined so as to satisfy the above relationship. At this time, the transfer time is T X (m/M)=100 X 192/768=25 microseconds.

Fiber-array Light Source

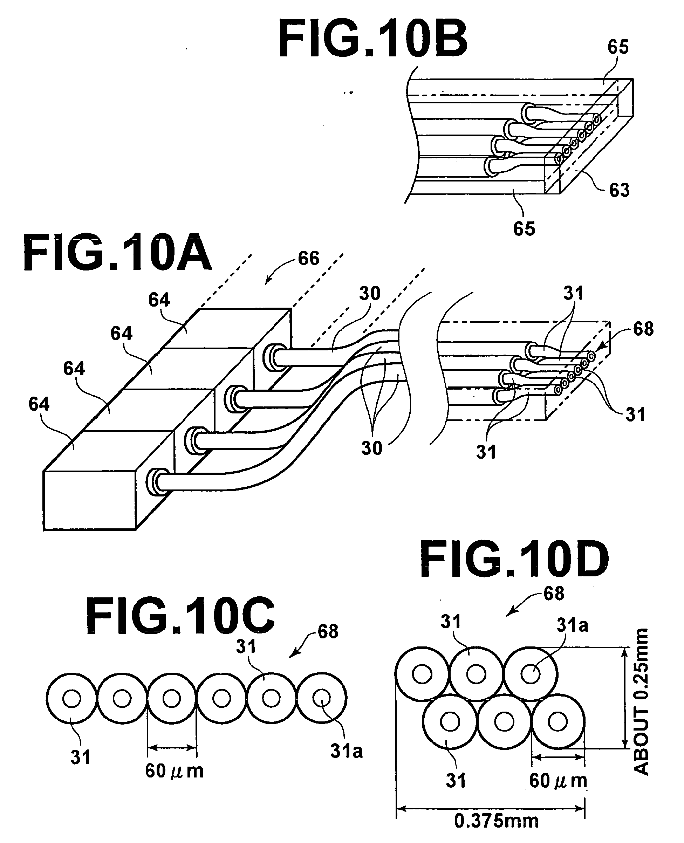

FIG. 10A is a perspective view of the fiber-array light source 66. The fiber-array light source 66 comprises a plurality (e.g., six) of laser modules 64, to each of which an end of a multimode optical fiber 30 is connected. Another optical fiber 31 having a core diameter identical to the core diameter of the multimode optical fiber 30 and a cladding diameter smaller than the cladding diameter of the multimode optical fiber 30 is connected to the other end of the multimode optical fiber 30. As illustrated in FIG. 10C, emission-end portions (light-emission points) of the optical fibers 31 may be arranged along a line in the main scanning direction (perpendicular to the subscanning direction) so as to form a laser-emission portion 68. Alternatively, as illustrated in FIG. 10D, it is possible to arrange the emission-end portions of the optical fibers 31 in two rows along the main scanning direction.

As illustrated in FIG. 10B, the emission-end portions of the optical fibers 31 are fixed by being sandwiched between two support plates 65 which have flat surfaces. In addition, in order to protect the end faces of the optical fibers 31, a protective plate 63, which is transparent and made of, for example, glass, is arranged on the light-emission side of the optical fibers 31. The protection plates 63 may be arranged in contact with or proximity to the end faces of the optical fibers 31. The end faces of the optical fibers 31 are likely to be contaminated with dust and deteriorate since the light density at the end faces of the optical fibers 31 is high. However, when the protective plate 63 is arranged as above, it is possible to prevent adhesion of dust to the end faces of the optical fibers 31, and delay deterioration of the end faces of the optical fibers 31.

Each multimode optical fiber 30 and each optical fiber 31 may be a step-index type, a graded-index type, or a composite-type optical fiber. For example, the multimode optical fibers 30 and the optical fibers 31 may be formed by using the step-index type optical fiber manufactured by Mitsubishi Cable Industries, Ltd.

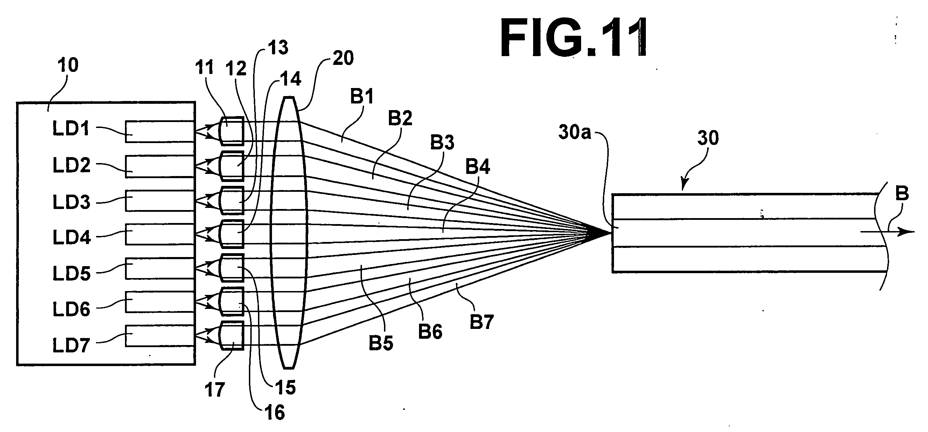

Each of the above laser modules 64 is constituted by a combined-laser-light source (fiber light source) illustrated in FIG. 11. The combined-laser-light source of FIG. 11 comprises a plurality of semiconductor lasers, collimator lenses 11 through 17, a condensing lens 20, and a multimode optical fiber 30. The plurality of semiconductor lasers are single- or multiple-transverse-mode GaN-based semiconductor lasers having a form of a chip. Although, generally, the combined-laser-light source of FIG. 11 may contain any number of semiconductor lasers, in FIG. 11, the number of the semiconductor lasers is assumed to be seven as an example, and the semiconductor lasers bear the reference numerals LD1 through LD7. The GaN-based semiconductor lasers LD1 through LD7 are arranged along a direction and fixed on a heat block 10. In addition, collimator lenses 11 through 17 are arranged in correspondence with the GaN-based semiconductor lasers LD1 through LD7, respectively.

The GaN-based semiconductor lasers LD1 through LD7 have an identical oscillation wavelength and an identical maximum output power. For example, the oscillation wavelength is 405 nm, and the maximum output power is 100 mW in the case where the GaN-based semiconductor lasers LD1 through LD7 are multimode semiconductor lasers, and 30 mW in the case where the GaN-based semiconductor lasers LD1 through LD7 are single-mode semiconductor lasers. Further, the oscillation wavelength is not limited to 405 nm, and the GaN-based semiconductor lasers LD1 through LD7 may have any oscillation wavelength in the range of 350 to 450 nm.

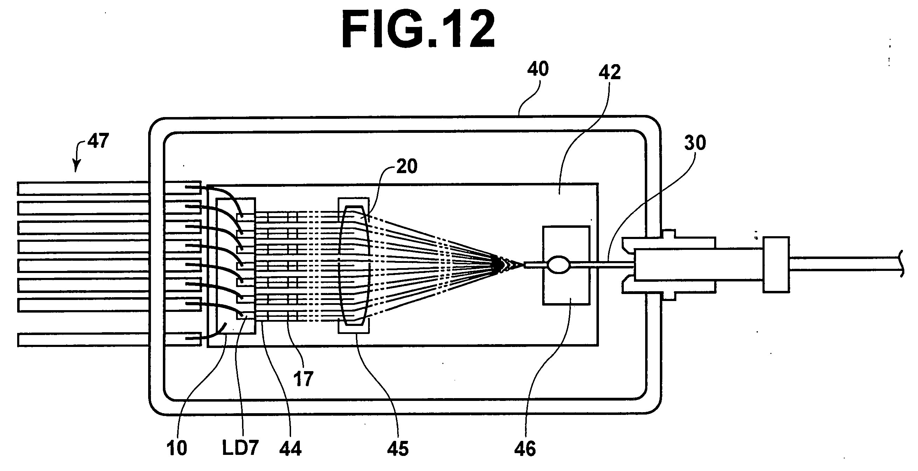

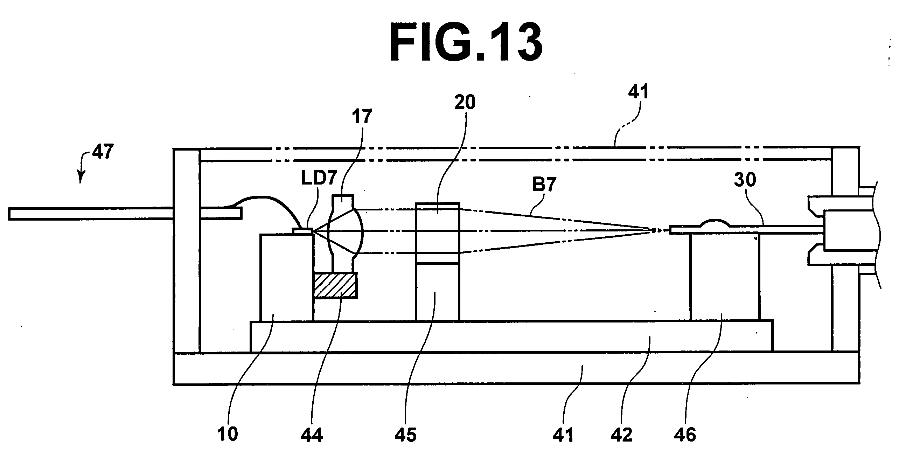

As illustrated in FIGS. 12 and 13, the above combined-laser-light source is contained in a box type package 40 together with other optical elements. The package 40 has an opening on its upper side, and is provided with a cover 41, which is produced so that the opening of the package 40 can be closed with the cover 41. When sealing gas is introduced after degassing, and the opening is closed with the cover 41, the above combined-laser-light source is hermetically sealed in the closed space (sealed space) which is realized by the package 40 and the cover 41.

A base plate 42 is fixed on the inner bottom surface of the package 40. The aforementioned heat block 10, a condensing-lens holder 45 for holding the condensing lens 20, and a fiber holder 46 for holding the light-entrance end of the multimode optical fiber 30 are fixed to the upper surface of the base plate 42. The light-emission end portion of the combined-laser-light source is led out of the package 40 through an opening formed in a wall of the package 40.

In addition, a collimator-lens holder 44 for holding the collimator lenses 11 through 17 is attached to a side wall of the heat block 10. Further, wirings 47 for supplying driving currents to the GaN-based semiconductor lasers LD1 through LD7 are led out of the package 40 through openings formed in a side wall of the package 40.

In FIGS. 12 and 13, in order to simplify the illustration, the reference numbers of the GaN-based semiconductor lasers LD1 to LD6 and the collimator lenses 11 through 16 are not shown.

FIG. 14 is a front view of a portion of the laser module of FIG. 12 in which the collimator lenses 11 through 17 are attached to the collimator-lens holder 44. Each of the collimator lenses 11 through 17 is formed to have an elongated shape which is obtained by cutting with parallel planes a round lens having an aspherical surface so as to leave a portion containing the optical axis of the round lens. The collimator lenses 11 through 17 can be formed, for example, by molding from resin or glass. The collimator lenses 11 through 17 are closely arranged in the direction along which the light-emission points of the GaN-based semiconductor lasers LD1 through LD7 are aligned (i.e., in the horizontal direction in FIG. 14) so that the length directions of the collimator lenses 11 through 17 are perpendicular to the direction along which the light-emission points are aligned.

Each of the GaN-based semiconductor lasers LD1 to LD7 comprises an active layer having an emission width of 2 micrometers. For example, the spread angle of each of laser beams B1 through B7 emitted from the GaN-based semiconductor lasers LD1 to LD7 is 10 degrees in the direction parallel to the active layer and 30 degrees in the direction perpendicular to the active layer.

The GaN-based semiconductor lasers LD1 to LD7 are arranged so that the light-emission points of the GaN-based semiconductor lasers LD1 to LD7 are aligned along a line parallel to the active layers of the GaN-based semiconductor lasers LD1 to LD7. Therefore, the laser beams B1 through B7 emitted from the GaN-based semiconductor lasers LD1 to LD7 respectively enter the collimator lenses 11 through 17 so that the direction of the greater spread angle of each of the laser beams B1 through B7 coincides with the length direction of each of the collimator lenses 11 through 17, and the direction of the smaller spread angle of each of the laser beams B1 through B7 coincides with the width direction of each of the collimator lenses 11 through 17 (which is perpendicular to the length direction).

The condensing lens 20 has a shape which is obtained by cutting with parallel planes a round lens having an aspherical surface so as to leave an elongated portion containing the optical axis of the round lens. Thus, the condensing lens 20 is elongated in the (horizontal) direction along which the collimator lenses 11 through 17 are arranged, and has a small dimension in the direction perpendicular to the direction along which the collimator lenses 11 through 17 are arranged. For example, the condensing lens 20 has a focal length $f_2$ of 23 mm and a numerical aperture (NA) of 0.2. The condensing lens 20 can be formed, for example, by molding from resin or glass.

Operations of Exposure System

The operations of the exposure system according to the present embodiment will be described below.

In each of the exposure heads 166 in the scanner 162, the laser beams B1 through B7 emitted from the GaN-based semiconductor lasers LD1 through LD7 in the fiber-array light source 66, which are divergent, are respectively collimated by the corresponding collimator lenses 11 through 17. Then, the collimated laser beams B1 through B7 are collected by the condensing lens 20, and converge on the light-entrance end face of the core 30a of the multimode optical fiber 30.

In this example, the collimator lenses 11 through 17 and the condensing lens 20 constitute an optical condensing system, and the optical condensing system and the multimode optical fiber 30 constitute an optical combining system. Thus, the laser beams B1 through B7 collected by the condensing lens 20 as above enter and propagate in the core 30a of the multimode optical fiber 30, in which the laser beams B1 through B7 are combined (optically multiplexed) into a single laser beam B. Then, the laser beam B is outputted from the multimode optical fiber 30, enters another optical fiber 31 coupled to the multimode optical fiber 30, and is outputted from the optical fiber 31.

As described before, in the laser emission end 68 of the fiber-array light source 66, a plurality of light-emission points are arranged along a line in the main scanning direction, and the intensity of the laser light emitted from each of the light-emission points is high. On the other hand, the conventional fiber light sources in each of which a light beam from a single semiconductor laser is merely coupled to a single optical fiber have low output power. Therefore, when the conventional fiber light sources are used in the exposure system, a great number of light sources are required to be used, and the optical fibers of the light sources are required to be arranged in a great number of rows. However, since the output power of the combined-laser-light source used in the present embodiment is high, it is possible to obtain desired output power even when the number of rows of the optical fibers arranged in the laser emission end of the combined-laser-light source is small (e.g., one).

Image data representing an exposure pattern is inputted into the controller (not shown) connected to the DMD 50, and is temporarily stored in a frame memory provided in the controller. The image data represents the density of each pixel by a binary value indicating whether or not a dot is to be recorded.

The stage 152 which holds a photosensitive sheet 150 on its surface by suction is moved at a constant speed by the aforementioned driving device (not shown) along the guides 158 from the upstream side to the downstream side of the U-shaped gate 160. When the stage 152 passes under the U-shaped gate 160, and the front edge of the photosensitive sheet 150 is detected by the sensors 164 fixed to the U-shaped gate 160, the image data stored in the frame memory is successively read out in groups of a plurality of lines, and a control signal for each of the exposure heads 166 is generated by the aforementioned data processing unit based on the image data which is read out. Then, each of the micromirrors 62 in the DMD 50 in each of the exposure heads 166 is on-off controlled by the mirror-actuation control unit based on the control signal.

When the laser beams emitted from the fiber-array light source 66 is applied to the DMD 50, portions of the laser beams reflected by portions of the micromirrors which are in the ON state pass through the lens systems 54 and 58, and form an image on the exposure plane 56 of the photosensitive sheet 150.

As described above, the laser beams emitted from the fiber-array light source 66 are on-off controlled on a pixel-by-pixel basis, so that the photosensitive sheet 150 is exposed on a pixel-by-pixel basis, where the pixels of the DMD 50 almost correspond to the pixels exposed on the photosensitive sheet 150 (and realized by the exposure areas 168).

As described before, according to the present embodiment, both of the partial actuation and the divided reset actuation are used for actuation of the DMD 50. Therefore, compared with the case where only one of the partial actuation and the divided reset actuation is used, the time necessary to update pixels is remarkably reduced. Thus, highspeed exposure is enabled.

In addition, since the photosensitive sheet 150 is moved at a constant speed together with the photosensitive sheet 150, the photosensitive sheet 150 is scanned in the direction opposite to the direction in which the photosensitive sheet 150 is moved, and bandlike exposed areas 170 are formed in correspondence with the exposure heads 166, respectively.

When the scanning of the photosensitive sheet 150 by using the scanner 162 is completed, and the rear edge of the photosensitive sheet 150 is detected by the sensors 164, the driving device (not shown) moves the stage 152 back to its initial position along the guides 158, where the initial position is the most upstream position of the guides 158. Thereafter, the driving device moves the stage 152 again from upstream to downstream along the guides 158 at the constant speed for the next exposure operation.

Further, in the so-called multiple exposure systems, identical scanning lines are multiply exposed with light beams reflected by different micromirrors. When DMDs in the multiple exposure systems are actuated as in the present embodiment, the resolution in the scanning direction can be improved by the divided reset actuation.

Variations of Divided Reset Actuation

(i) In the above embodiment, the numbers of the micromirror arrays in the respective regions for the divided reset actuation are approximately identical. However, it is unnecessary to equalize the numbers of the micromirror arrays in the respective regions for the divided reset actuation. That is, it is possible to differentiate the number of micromirror arrays in at least one region from the numbers of micromirror arrays in the other regions. For example, in the case where only 240 micromirror arrays are used for partial actuation, and the time t necessary to transfer control signals to all of the regions for the divided reset actuation is 32 micrometers, and the time u necessary to reset micromirrors in each of the regions (the reset time of each region) is 18 micrometers, it is preferable that the number d of division is 3, 4, or 5 in consideration of the condition obtained by the following calculation.

$$d \geq t/(t-u) = 32/(32-18) = 2.29$$

Therefore, in the case where d=3, for example, the numbers of micromirror arrays in the regions 1 through 3 may be respectively: 96, 96, and 48; or 96, 48, and 96; or 48, 96, and 96. In addition, in the case where d=4, for example, the numbers of micromirror arrays in the regions 1 through 4 may be respectively: 96, 48, 48, and 48; or 48, 96, 48, and 48; or 48, 48, 96, and 48; or 48, 48, 48, and 96. Further, in the case where d=5, the number of micromirror arrays in each of the regions 1 through 5 may be 48, as in the embodiment explained before.

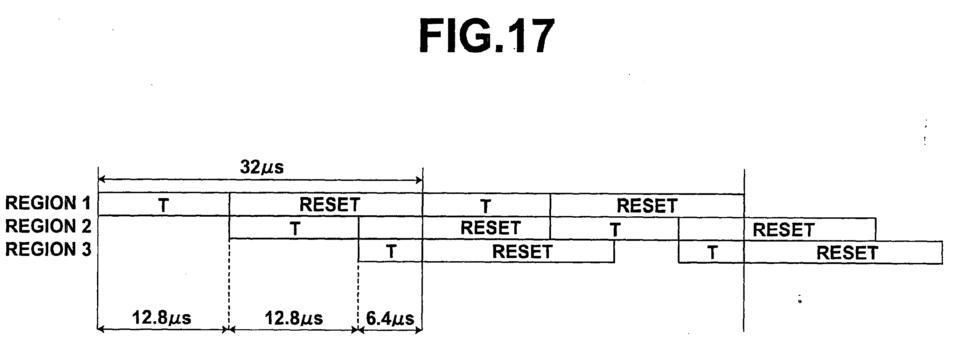

Even when the numbers of micromirror arrays in the respective regions are different, it is possible to achieve a similar effect to the effect which is achieved when the numbers of micromirror arrays in the respective regions are identical. For example, FIG. 17 is a timing diagram indicating timings in the case where the numbers of micromirror arrays in the regions 1 through 3 are 96, 96, and 48, respectively. In addition, since the regions for the divided reset actuation are determined as mentioned above, the number of transfer operations can be reduced. Therefore, it is possible to simplify the actuation control.

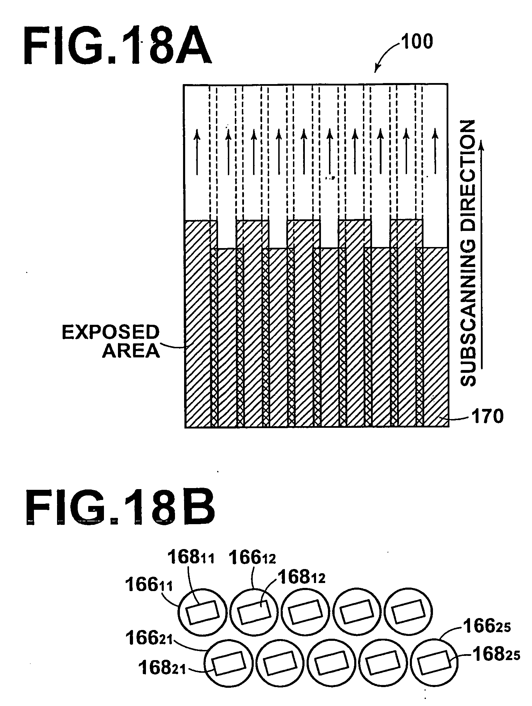

(ii) As illustrated in FIGS. 2, 3A, and 3B, in the embodiment explained before, the exposure areas of the DMDs 50 are not rotated from the scanning direction. However, it is possible to slightly rotate the DMDs 50 from the scanning direction so as to slightly rotate the exposure areas 168 and reduce the pitch of the scanning lines, for example, as illustrated in FIG. 18B, where five exposure heads 166 are arranged in the head-array direction in each of the first and second rows so that the exposure heads arranged in each row are shifted by a predetermined amount in the head-array direction from exposure heads linearly arranged in an adjacent row. FIG. 18A shows exposed areas which are produced with the exposure heads 166 illustrated in FIG. 18B. Further, by slightly rotating the DMDs 50 from the scanning direction, it is possible to form a so-called multiple exposure system, in which identical scanning lines are multiply exposed with light beams reflected by different micromirrors.

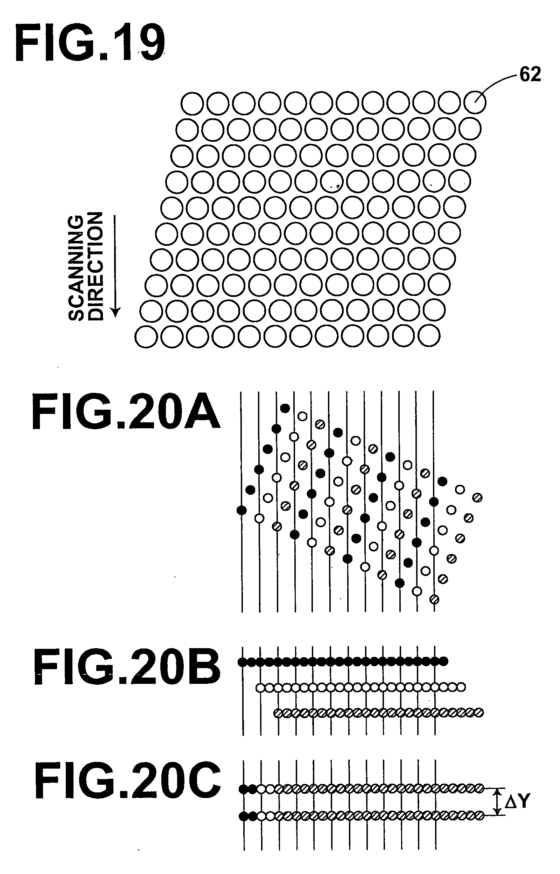

Alternatively, instead of arranging the DMDs 50 in a rotated orientation, the micromirrors 62 per se may be slightly obliquely arranged with respect to the scanning direction as illustrated in FIG. 19. Further, it is possible to adopt another arrangement or method which makes laser beams reflected by the micromirrors 62 (constituting each DMD 50) projected onto spots on the photosensitive sheet 150 as illustrated in FIG. 19. For example, it is possible to use DMDs 50 in each of which micromirrors are rectangularly arranged, and expose the photosensitive sheet 150 by using only micromirrors in the area as illustrated in FIG. 19.

Since the divided reset actuation is performed in the present invention, it is possible to increase the resolution in the scanning direction without decreasing the scanning speed, by applying the present invention to the multiple exposure system. Specifically, when the DMDs 50 are arranged in an orientation slightly rotated from the scanning direction so that each scanning line is scanned with laser beams reflected by more than one micromirror, and the divided reset actuation is performed, it is possible to produce a group of exposed spots at a different position for each of the regions for the divided reset actuation. Therefore, the resolution in the scanning direction can be increased without decreasing the scanning direction.

In order to clarify the effect of increasing the resolution, first, the exposed areas in the case where multiple exposure is simply performed without performing the divided reset actuation is explained. FIGS. 20A, 20B, and 20C show exposed areas produced by triple exposure, in which each scanning line is scanned with three different micromirrors. In FIGS. 20A, 20B, and 20C, the vertical lines indicate scanning lines. FIG. 20A shows positional relationships between the scanning lines and a portion of a DMD which is partially actuated.

When triple exposure is performed without the divided reset actuation, as illustrated in FIG. 20B, a line is exposed with each group of micromirrors (i.e., each of a group of micromirrors indicated by hatched circles, a group of micromirrors indicated by blank circles, and a group of micromirrors indicated by filled circles). Finally, the three lines exposed with the three groups of micromirrors overlap each other, and lines as illustrated in FIG. 20C are exposed.

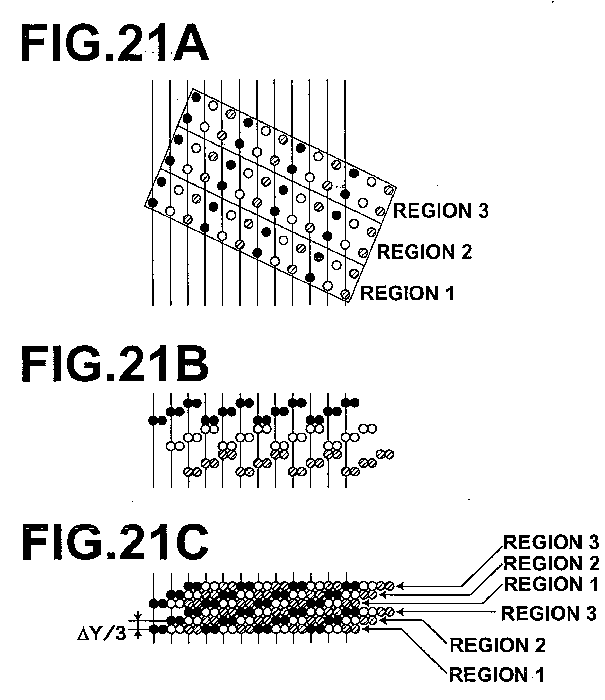

On the other hand, FIGS. 21A, 21B, and 21C show exposed areas produced by triple exposure while performing the divided reset actuation. In the example of FIGS. 21A, 21B, and 21C, the number of division into regions in the divided reset actuation is equal to the multiplicity, three. In the case where triple exposure is performed with divided reset actuation, for example, the exposed spots produced with the micromirrors indicated by the hatched circles do not form a single line, and a group of exposed spots corresponding to each of the regions are separated by $\Delta Y/3$ in the scanning direction from another group of exposed spots corresponding to an adjacent one of the regions, since the input timing of the control signals supplied to each of the regions is shifted from the input timing of the control signals supplied to an adjacent one of the regions due to the divided reset actuation. In addition, the micromirrors indicated by the blank circles and the micromirrors indicated by the filled (black) circles produce groups of exposed spots in a similar manner to the micromirrors indicated by the hatched circles. Finally, the above groups of exposed spots produced with the micromirrors indicated by the hatched, blank, and filled (black) circles are combined, and a line is exposed with the micromirrors in each of the regions 1 through 5 as illustrated in FIG. 21C. When the gap between adjacent lines in FIG. 20C is $\Delta Y$, the gap between adjacent lines in FIG. 21C becomes $\Delta Y/3$. That is, it is possible to increase the resolution in the scanning direction. Although, in the above example, the number of division into regions in the divided reset actuation is equal to the multiplicity, it is generally unnecessary that the number of division is equal to the multiplicity.

In addition, in the case where the divided reset actuation is performed, the positions of the exposed spots (dots) can be adjusted by controlling the output timings of the control signals supplied to the respective regions according to the movement of the photosensitive sheet 150. For example, the positions of the exposed spots (dots) can be dispersed. Thus, it is possible to obtain an exposed image having a desired resolution by controlling the output timings of the control signals supplied to the respective regions so that spots (dots) exposed on the photosensitive sheet 150 are desirably located. That is, when the above control is realized, it is possible to increase the resolution without decreasing the moving speed of the photosensitive sheet 150.

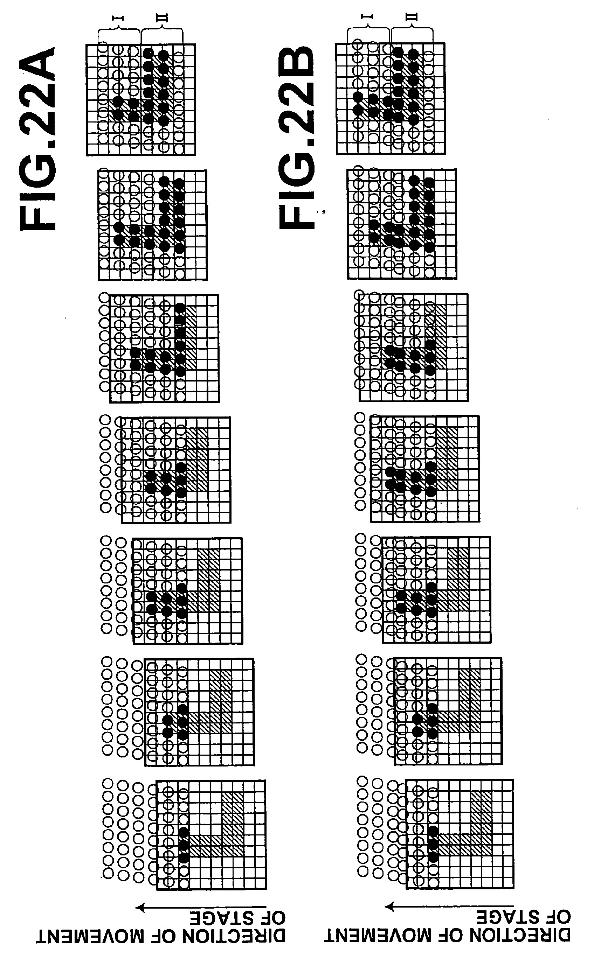

Further, in the case where the divided reset actuation is performed, it is preferable that the control signals are generated in consideration of the movement of the photosensitive sheet 150 and the differences in the input timings of the control signals to the respective regions. That is, it is preferable to generate image-recording data for each dot based on image data representing the image to be exposed, in consideration of the movement of the photosensitive sheet 150 and the differences in the input timings of the control signals to the respective regions, and reflect the image-recording data in the control signals to be outputted to the spatial light-modulation device. FIGS. 22A and 22B are diagrams provided for explaining the relationships between images which are exposed on the photosensitive sheet 150 and control signals which are inputted into a DMD 50. Each of FIGS. 22A and 22B shows positions of spots (schematically indicated by circles) onto which laser beams reflected from micromirrors constituting the DMD are projected, relative to positions of the photosensitive sheet 150 (schematically indicated as a square by bold lines) in seven successive stages in the progress of scanning (illustrated from left to right). In the examples of FIGS. 22A and 22B, the desired image is an image of the character "L" and indicated with hatched squares, the micromirrors in the DMD are divided into the regions I and II, and the states of the control signals inputted into the DMD 50 are schematically indicated by blank and filled circles, where the blank circles indicate OFF states, and the filled circles indicate ON states.

Specifically, in the example of FIG. 22A, the control signals are generated without consideration of the movement of the photosensitive sheet 150 and differences in the input timings of the control signals between the regions I and II. In the case where the divided reset actuation is performed, the photosensitive sheet 150 moves during the time gap between the input timings in the regions I and II. Therefore, when the control signals are inputted without consideration of the movement of the photosensitive sheet 150 during the time gaps between the input timings in the regions I and II, the image actually exposed on the photosensitive sheet 150 deviates from the desired image. On the other hand, in the example of FIG. 22B, the control signals are generated in consideration of the movement of the photosensitive sheet 150 during the time gaps between the input timings in the regions I and II in such a manner that the gap between the groups of spots corresponding to the regions I and II is slightly reduced. Thus, it is possible to actually expose an image which is closer to the desired image. However, in practice, it is possible to adopt either of the methods illustrated in FIGS. 22A and 22B according to a requested resolution.

Other Variations and Additional Matters

(i) In the above examples, the exposure heads comprise a DMD as a spatial light-modulation device. The DMD is a reflection-type, spatial light-modulation device. Alternatively, it is possible to use a transmission-type, spatial light-modulation device. For example, the spatial light-modulation devices may be: MEMS (micro electromechanical systems) type SLMs (spatial light modulators); optical elements which modulate transmitted light by the electro-optical effect, e.g., PLZT (lanthanum-doped lead zirconate titanate) elements; or liquid crystal shutter arrays, e. g., FLC (ferroelectric liquid crystal) shutters; where microsystems in which micro-size, sensors, actuators, and control circuits are integrated by using the micromachining technology based on the IC manufacturing processes are collectively called MEMS, and the MEMS type SLMs are spatial light-modulation devices which are actuated by electromechanical operations utilizing electostatic forces.

Further, it is possible to form a spatial light-modulation device by two-dimensionally arranging GLVs (grating light valves).

When the GLVs or the transmission-type, spatial light-modulation devices such as the liquid crystal shutter arrays are used, it is possible to use a lamp or the like as the light source.

(ii) In the present embodiment, the fiber-array light source comprising arrayed combined-laser-light sources is used as a laser-light source. However, other types of light sources can be used. For example, it is possible to use a fiber-array light source in which a plurality of fiber light sources are arrayed, and each of the fiber light sources is constituted by a single semiconductor laser having a single light-emission point and a single optical fiber outputting laser light which is emitted from the semiconductor laser and enters the optical fiber.

Further, it is possible to use a light source in which a plurality of light-emission points are two-dimensionally arranged. For example, the plurality of light-emission points may be a plurality of laser diodes or a plurality of organic electroluminescent elements. In this case, when the plurality of light-emission points are respectively arranged in correspondence with pixels, the aforementioned construction for spatial light modulation can be dispensed with.

(iii) In the above examples, the entire area of the photosensitive sheet 150 is scanned with the scanner 162 in the X-direction in a single scanning cycle, as illustrated in FIG. 17.

Alternatively, it is possible to scan the entire photosensitive sheet 150 in a plurality of scanning cycles, as illustrated in FIGS. 18A and 18B. In the exposure method illustrated in FIGS. 18A and 18B, after a portion of the photosensitive sheet 150 is scanned with the scanner 162 in the X-direction in a scanning cycle, the scanner 162 is moved in the Y direction by one step, and the adjacent portion of the photosensitive sheet 150 is scanned in the X-direction in the next scanning cycle. Then, similar operations are repeated until scanning of the entire photosensitive sheet 150 is completed.

(iv) Although the exposure system in the present embodiment is a so-called flat-head type exposure system, the present invention can also be applied to so-called outer-drum type exposure systems, which comprise a drum around which a photosensitive material is placed.

(v) For example, the exposure system according to the present embodiment can be used for formation of color filters in manufacturing processes of liquid-crystal display devices (LCDs), and exposure of dry film resists (DFRs) in manufacturing processes of printed wiring boards (PWBs), thin-film transistors (TFTs), or plasma display panels (PDPs).

(vi) In the exposure system according to the present embodiment, either of the photon-mode photosensitive material and the heat-mode photosensitive material can be used. In the photon-mode photosensitive material, information is recorded directly by exposure to light. In the heat-mode photosensitive material, information is recorded by heat generated by exposure to light. When the photon-mode photosensitive material is used, GaN-based semiconductor lasers or wavelength-conversion solid-state lasers can be used as the laser devices. When the heat-mode photosensitive material is used, AlGaAs-based semiconductor lasers (infrared lasers) or solid-state lasers can be used as the laser devices.

(vii) The divided reset actuation according to the present invention can also be applied to image-recording control in printers such as inkjet printers. For example, image-recording dots produced by squirts of ink can be controlled in a similar manner to the present invention. That is, the present invention can also be applied to image-recording control in printers by substituting the image-recording elements in the present invention by the elements which produce image-recording dots by squirts of ink or the like.

(viii) In addition, all of the contents of the Japanese patent applications Nos. 2003-277613 and 2004-205415 are incorporated into this specification by reference.

**Claims**

1. An image-recording method for recording an image by relatively moving an image-recording head with respect to an image-recording plane in a predetermined direction along the image-recording plane, and realizing image formation on the image-recording plane with incident light modulated by a spatial light-modulation device, where the spatial light-modulation device is included in the image-recording head, and contains a plurality of rows of image-recording elements , and each of the image-recording elements modulates the incident light according to one of a plurality of control signals which is inputted to said each of the image-recording elements;
   **characterized in** comprising the steps of:

   (a) determining a plurality of regions each containing at least one of said plurality of rows of image-recording elements by dividing said plurality of rows of image-recording elements;
   (b) outputting ones of said plurality of control signals to each of the plurality of regions on a region-by-region basis in succession; and
   (c) controlling ones of said image-recording elements in each of said plurality of regions on a region-by-region basis so that the ones of the image-recording elements start modulation of said incident light when an operation of inputting ones of said plurality of control signals into said each of the plurality of regions is completed.

2. An image-recording method according to claim 1, wherein said plurality of control signals are outputted to only a portion of said plurality of rows of image-recording elements, and said plurality of regions are determined by dividing said portion of said plurality of rows of image-recording elements.

3. An image-recording method according to either one of claims 1 and 2, wherein the number of said plurality of regions satisfies a relationship, $d \geq t/(t-u)$, where d is the number of said plurality of regions, t is a time until operations of inputting said plurality of control signals into all of said plurality of regions are completed, and u is a time necessary for ones of said image-recording elements in each of said plurality of regions to modulate said incident light.

4. An image-recording method according to either one of claims 1 to 3, wherein the number of at least one of the plurality of rows of image-recording elements constituting one of said plurality of regions is different from the number of at least one of the plurality of rows of image-recording elements constituting another of said plurality of regions.

5. An image-recording method according to either one of claims 1 to 4, wherein said image is recorded in such a manner that image-recording points recorded by using said spatial light-modulation device are shifted in a scanning direction by an amount which is predetermined for each of said plurality of regions.

6. An image-recording method according to claim 5, wherein image-recording data corresponding to each of said image-recording points is generated based on image data representing said image to be recorded on said image-recording plane, said amount predetermined for each of said plurality of regions, and a speed at which said image-recording head relatively moves with respect to said image-recording plane, and said plurality of control signals are generated based on said image-recording data.

7. An image-recording method according to either one of claims 5 and 6, wherein said image is recorded on said image-recording plane by performing multiple recording operations with a multiplicity of N, which is a natural number greater than one.

8. An image-recording method according to claim 7, wherein the number of said plurality of regions is equal to said natural number N.

9. An image-recording method according to either one of claims 5 to 8, wherein projected spots are produced on said image-recording plane by projection of said incident light modulated by at least a portion of said image-recording elements which is determined to be actually used for recording the image, so that the projected spots are arranged along a direction which makes a predetermined angle with said scanning direction.

10. An image-recording method according to claim 9, wherein said spatial light-modulation device is arranged in such a manner that lines formed by ones of said image-recording elements form a predetermined angle greater than zero with said scanning direction.

11. An image-recording method according to claim 9, wherein said image-recording elements are arranged in said spatial light-modulation device in such a manner that lines formed by ones of said image-recording elements form a predetermined angle greater than zero with said scanning direction.

12. An image-recording method according to either one of claims 1 to 11, wherein timings of output of said control signals to each of said plurality of regions are adjusted according to a speed at which said image-recording head relatively moves with respect to said image-recording plane.

13. An image-recording method according to claim 12, wherein timings of output of said control signals to each of said plurality of regions are adjusted according to a desired arrangement of image-recording dots which are to be recorded on said image-recording plane.

14. An image-recording method according to either one of claims 1 to 13, wherein said control signals are outputted to said plurality of regions in succession from the most downstream one of the plurality of regions in said scanning direction.

15. An image-recording method according to either one of claims 1 to 14, wherein said control signals to be outputted to each of said plurality of regions are generated according to a speed at which said image-recording head relatively moves with respect to said image-recording plane.

16. An image-recording apparatus including an image-recording head which forms on a image-recording plane an image of incident light modulated by a spatial light-modulation device, and is relatively movable with respect to the image-recording plane in a predetermined direction along the image-recording plane, where the spatial light-modulation device is included in the image-recording head, and contains a plurality of rows of image-recording elements, and each of the image-recording elements modulates the incident light according to one of a plurality of control signals which is inputted to said each of the image-recording elements;
**characterized in** comprising a control unit which outputs ones of said plurality of control signals to each of a plurality of regions of said spatial light-modulation device each containing at least one of said plurality of rows of image-recording elements, on a region-by-region basis in succession, and controls ones of said image-recording elements in each of said plurality of regions on a region-by-region basis so that the ones of the image-recording elements start modulation of said incident light when an operation of inputting ones of said plurality of control signals into said each of the plurality of regions is completed.

**17.** An image-recording apparatus according to claim 16, wherein said plurality of regions extend to only a portion of said plurality of rows of image-recording elements, and said control unit outputs said plurality of control signals to only said portion of the plurality of regions.

**18.** An image-recording apparatus according to either one of claims 16 and 17, wherein the number of said plurality of regions satisfies a relationship, $d \geq t/(t-u)$, where d is the number of said plurality of regions, t is a time until operations of inputting said plurality of control signals into all of said plurality of regions are completed, and u is a time necessary for ones of said image-recording elements in each of said plurality of regions to modulate said incident light.

**19.** An image-recording apparatus according to either one of claims 16 to 18, wherein the number of at least one of the plurality of rows of image-recording elements constituting one of said plurality of regions is different from the number of at least one of the plurality of rows of image-recording elements constituting another of said plurality of regions.

**20.** An image-recording apparatus according to either one of claims 16 to 19, wherein said control unit outputs said plurality of control signals so that image-recording points recorded by using said spatial light-modulation device are shifted in a scanning direction by an amount which is predetermined for each of said plurality of regions.

**21.** An image-recording apparatus according to claim 20, wherein said control unit generates image-recording data corresponding to each of said image-recording points based on image data representing said image to be recorded on said image-recording plane, said amount predetermined for each of said plurality of regions, and a speed at which said image-recording head relatively moves with respect to said image-recording plane, and said control unit also generates said plurality of control signals based on said image-recording data.

**22.** An image-recording apparatus according to either one of claims 20 and 21, wherein said image is recorded on said image-recording plane by performing multiple recording operations with a multiplicity of N, which is a natural number greater than one.

**23.** An image-recording apparatus according to claim 22, wherein in said control unit, the number of said plurality of regions is set equal to said natural number N.

**24.** An image-recording apparatus according to either one of claims 21 to 23, wherein projected spots are produced on said image-recording plane by projection of said incident light modulated by at least a portion of said image-recording elements which is determined to be actually used for recording the image, and the projected spots are arranged along a direction which makes a predetermined angle with said scanning direction.

**25.** An image-recording apparatus according to claim 24, wherein said spatial light-modulation device is arranged in such a manner that lines formed by ones of said image-recording elements form a predetermined angle greater than zero with said scanning direction.

**26.** An image-recording apparatus according to claim 24, wherein said image-recording elements are arranged in said spatial light-modulation device in such a manner that lines formed by ones of said image-recording elements form a predetermined angle greater than zero with said scanning direction.

**27.** An image-recording apparatus according to either one of claims 16 to 26, wherein said spatial light-modulation device is a micromirror device in which a plurality of micromirrors are arranged as said image-recording elements, and each of the plurality of micromirrors has a reflection surface arranged at a tilt angle which is changeable according to one of said plurality of control signals.

**28.** An image-recording apparatus according to either one of claims 16 to 26, wherein said spatial light-modulation device is a liquid-crystal shutter array in which a plurality of liquid-crystal cells are arranged as said image-recording elements, and each of the plurality of liquid-crystal cells can stop transmission of light according to one of said plurality of control signals.

**29.** An image-recording apparatus according to either one of claims 16 to 28, wherein said control unit adjusts timings of output of said control signals to each of said plurality of regions according to a speed at which said image-recording head relatively moves with respect to said image-recording plane.

**30.** An image-recording apparatus according to claim 29, wherein said control unit adjusts timings of output of said control signals to each of said plurality of regions according to a desired arrangement of image-recording dots which are to be recorded on said image-recording plane.

**31.** An image-recording apparatus according to either one of claims 16 to 30, wherein said control unit outputs said control signals to said plurality of regions in succession from the most downstream one of the plurality of regions in said scanning direction.

**32.** An image-recording apparatus according to either one of claims 16 to 31, wherein said control unit generates said control signals to be outputted to each of said plurality of regions according to a speed at which said image-recording head relatively moves with respect to said image-recording plane.

# FIG.1

162

158

DIRECTION OF
MOVEMENT OF STAGE

164

152

150

154

156

160

154

# FIG.2

166

162

150   152

168

170

SCANNING DIRECTION

DIRECTION OF
MOVEMENT OF STAGE

# FIG.3A

EXPOSED AREA

SUBSCANNING DIRECTION

ONE CYCLE OF SCANNING AT
LOW CONSTANT SPEED (80mm/s)

100

170

# FIG.3B

$166_{11}$

$168_{11}$

$166_{12}$

$168_{12}$

$166_{21}$

m ROWS

$168_{21}$

$166_{31}$  $168_{31}$

n COLUMNS

# FIG.4

EP 1 500 515 A2

# FIG.5A

# FIG.5B

# FIG.6

FIG.7A

FIG.7B

FIG.8

| | REGION 1 |
| | REGION 2 |
| | REGION 3 |
| | REGION 4 |
| | REGION 5 |

# FIG.9A

| | 25us | | | | |
|---|---|---|---|---|---|
| | 5us | 20us | | | |
| REGION 1 | T | RESET | T | RESET | |
| REGION 2 | | T | RESET | T | RESET |
| REGION 3 | | T | RESET | T | RESET |
| REGION 4 | | T | RESET | T | RESET |
| REGION 5 | | | T | RESET | T | RESET |

# FIG.9B

45us
25us
5us
20us

REGION 1~5 | T | T | T | T | T | RESET | T | T | T | T | T | RESET

REGION 1    REGION 3    REGION 5
REGION 2    REGION 4

EP 1 500 515 A2

# FIG.10B

65

63

65

# FIG.10A

64

64

64

64

66

30

30

30

31

68

31

31

# FIG.10D

68

31

31a

31

60 μm

0.375mm

ABOUT 0.25mm

# FIG.10C

68

31

31

31a

60 μm

# FIG.11

EP 1 500 515 A2

FIG.12

# FIG.13

EP 1 500 515 A2

# FIG.14

# FIG.15

# FIG.16

REGION 1
REGION 2
REGION 3
REGION 4
REGION 5

# FIG.17

EP 1 500 515 A2

|  | 32μs | | | |
|---|---|---|---|---|
| REGION 1 | T | RESET | T | RESET |
| REGION 2 | | T | RESET | T | RESET |
| REGION 3 | | | T | RESET | T | RESET |

12.8μs    12.8μs    6.4μs

# FIG.18A

100

EXPOSED AREA

SUBSCANNING DIRECTION

170

# FIG.18B

$168_{11}$  $166_{12}$

$166_{11}$  $168_{12}$

$166_{21}$  $166_{25}$

$168_{21}$  $168_{25}$

# FIG.19

62

SCANNING DIRECTION

# FIG.20A

# FIG.20B

# FIG.20C

ΔY

# FIG.21A

REGION 3

REGION 2

REGION 1

# FIG.21B

# FIG.21C

REGION 3
REGION 2
REGION 1

REGION 3

REGION 2

REGION 1

$\Delta Y/3$

FIG.22A

FIG.22B

DIRECTION OF MOVEMENT
OF STAGE

DIRECTION OF MOVEMENT
OF STAGE

EP 1 500 515 A2

35

# FIG.23

# FIG.24A

162

150

Y

X

# FIG.24B

EXPOSED AREA

150

Y

X

162